# EUROPÄISCHE PATENTSCHRIFT

(11) **EP 0 664 839 B1**
(45) Veröffentlichungstag und Bekanntmachung des Hinweises auf die Patenterteilung: **27.03.1996**
(21) Anmeldenummer: 93918892.6
(22) Anmeldetag: 18.08.1993
(51) Int. Cl.: C23C 14/54, C23C 14/30

(54) **VERFAHREN UND EINRICHTUNG ZUR PROZESSSTABILISIERUNG BEIM ELEKTRONENSTRAHLVERDAMPFEN**
PROCESS AND ARRANGEMENT FOR STABILISING AN ELECTRON-BEAM VAPORISATION PROCESS
PROCEDE ET DISPOSITIF DE STABILISATION DU PROCESSUS LORS DE L'EMISSION THERMOELECTRIQUE

(30) Priorität: 19.10.1992 DE 4235200
(43) Veröffentlichungstag der Anmeldung: 02.08.1995
(73) Patentinhaber: FRAUNHOFER-GESELLSCHAFT ZUR FÖRDERUNG DER ANGEWANDTEN FORSCHUNG E.V., D-80636 München (DE)
(72) Erfinder: KIRCHHOF, Volker, D-01324 Dresden (DE); METZNER, Christoph, D-01324 Dresden (DE); GOEDICKE, Klaus, D-01307 Dresden (DE); SCHILLER, Siegfried, D-01324 Dresden (DE); KERN, Heinz, D-01219 Dresden (DE)
(86) Internationale Anmeldenummer: DE9300749
(87) Internationale Veröffentlichungsnummer: WO9409177

(56) Entgegenhaltungen:
- US-A- 4 166 784
- US-A- 4 407 709
- PATENT ABSTRACTS OF JAPAN, vol. 9, no. 145 (C-287), 09 February 1985

## Beschreibung

Die Erfindung betrifft ein Verfahren und die zugehörige Einrichtung zur Prozeßstabilisierung bei der physikalischen Dampfabscheidung durch Elektronenstrahlverdampfung unter Verwendung einer Elektronenkanone vom Axialtyp. Sie findet Anwendung bei Prozessen zur Abscheidung von Metallen und Verbindungen auf Substraten bei hoher Verdampfungsrate. Derartige Prozesse dienen vorzugsweise zur Oberflächenveredelung von Halbzeugen und Fertigteilen für die verschiedensten Anwendungsgebiete; so z. B. in der Metallurgie, im Maschinenbau, der Optik und der Verpackungs- und Glasindustrie.

Die Dampfabscheidung mittels Elektronenstrahlverdampfung unter Verwendung von Elektronenkanonen hoher Leistung eröffnet die Möglichkeit, große Substratoberflächen bei niedrigen Kosten zu beschichten. Durch eine große Vielfalt der verdampfbaren Materialien sind sehr unterschiedliche Anwendungsmöglichkeiten gegeben. Insbesondere zeichnen sich auch durch die direkte Verdampfung von Verbindungen, z. B. Oxiden, meist bei reaktiver Prozeßführung unter Einlaß eines reaktiven Gases wie Sauerstoff, interessante Anwendungsmöglichkeiten ab. Die Qualität der abgeschiedenen Schichten wird nur dann gesichert, wenn die Schichtbildung unter stabilen Prozeßbedingungen, insbesondere bei vorgegebener konstanter und für die gesamte Substratoberfläche gleicher Abscheiderate erfolgt. Die Einhaltung konstanter Abscheidebedingungen muß bei diesem Verfahren im Produktionsbetrieb über Zeiträume von vielen Stunden gesichert sein.

Es ist bekannt, zur Einhaltung konstanter Abscheidungsbedingungen nach verschiedenen Methoden direkt und indirekt die Verdampfungsrate bzw. die in einer bestimmten Zeit abgeschiedene Schichtdicke zu messen und das gewonnene Signal zur Regelung zu verarbeiten. Seit langem ist die Tatsache bekannt, daß sich die Verdampfungsund Abscheiderate nicht allein durch die Einstellung der Verdampfungsleistung vorgeben und konstant halten läßt, so daß diese Methoden für Beschichtungsprozesse über große Zeiträume bei hohen Anforderungen an die Schichtqualität nicht geeignet sind.

Es ist weiterhin der Einsatz von Mikrowaagen, die Bestimmung der Frequenzänderung eines Schwingquarzes oder die Messung optischer bzw. elektrischer Eigenschaften aufgedampfter Schichten zur Prozeßkontrolle bekannt (H. Frey, G. Kienel; Dünnschichttechnologie, VDI-Verlag Düsseldorf, 1987). Diese Methoden sind zur Prozeßkontrolle bei kontinuierlichem Betrieb nicht geeignet. Besonders bei der Abscheidung von Schichten mit hoher Rate werden die Sensoren so stark durch kondensierende Schichten beeinflußt, daß sie nicht zur kontinuierlichen Signalgewinnung und Prozeßstabilisierung geeignet sind. Werden die Sensoren außerhalb der Zone hoher Dampfdichte an peripheren Stellen der Verdampfungsanordnung angeordnet, so sind diese Störungen durch Bedampfung zwar geringer, aber die Signale sind nicht relevant für den Prozeß.

Noch höhere Anforderungen an die Prozeßkontrolle, auch bezüglich eines lokalen Auflösungsvermögens, entstehen, wenn großflächige Verdampfungsanordnungen eingesetzt werden. Höhere Anforderungen ergeben sich außerdem bei der Verdampfung unter Einlaß eines reaktiven Gases und bei der Verdampfung sublimierender Materialien. Letztere weisen durch Kraterbildung auf der Oberfläche des Verdampfungsgutes Instabilitäten mit örtlich und zeitlich schwankender Dampfdichteverteilung und Inhomogenitäten bei der Dampfausbreitung auf. Durch Dissoziation, vornehmlich beim Verdampfen von Verbindungen, und zeitlich schwankende Gasabgabe sind weitere Ursachen für Instabilitäten des Verdampfungsprozesses bedingt. Die bekannten Methoden der Schichtmeßtechnik bzw. zur Messung der Verdampfungsrate liefern neben den oben genannten Mängeln beim kontinuierlichen Messen und beim Verdampfen mit hoher Verdampfungsrate insbesondere keine Meßwerte mit guter zeitlicher und örtlicher Auflösung.

Lediglich Methoden, die Plasmakenngrößen oder die optische Emission eines durch Stoßprozesse in einer Gasentladung angeregten Plasmas nutzen, zeichnen sich durch eine gute zeitliche Auflösung dieser Meßgröße aus. Hierbei handelt es sich um Vakuumzerstäubungsprozesse. Bei diesen Prozessen wird die Intensität von Spektrallinien genutzt, um beim reaktiven Zerstäuben den Fluß des eingelassenen Reaktivgases zu steuern (US-A- 4.407.709). Es ist auch bekannt, für die Monitorierung von Plasmaprozessen einen Massenanalysator mit einem Ionisierungssystem zu verwenden (US-A-4.362.936). Weiterhin ist es bekannt, das Verhältnis der Intensität zweier Spektrallinien alternativ zu anderen Mitteln zur Monitorierung des Zerstäubungsprozesses zu nutzen (US-A-4.166.784). Es ist auch bekannt, für reaktive Zerstäubungsprozesse die Monitorierung mittels optischer Emissionslinien des Plasmas vorzunehmen (DD-A1- 239 811).

Diese genannten Lösungen, die in Zerstäubungseinrichtungen Anwendung finden, setzen aufgrund des physikalischen Grundprozesses ein dichtes Plasma voraus, dessen optisches Emissionsspektrum, das in Form einzelner charakteristischer Spektrallinien existiert, zur Monitorierung des Prozesses genutzt werden kann. Dabei ist das Plasma großräumig und örtlich konstant, so daß das Problem des lokalen Auflösungsvermögens nicht besteht. Auch die Probleme der Beschichtung der Sensoren, die beim Hochrate-Verdampfen bestehen, sind für Plasmaprozesse infolge der größenordnungsmäßig geringeren Beschichtungsrate nicht gravierend und deshalb auch nicht gelöst worden.

Beim Verdampfen existiert im allgemeinen kein Plasma in der Verdampfungskammer. Statt dessen emittieren die heißen Anteile der Oberfläche des Verdampfungsgutes und ggf. die Heizelemente eine Temperaturstrahlung mit einem Kontinuum von Wellenlängen, die nicht für die Prozeßparameter charakteristisch und damit für die Prozeßmonitorierung ungeeignet sind. Es gibt deshalb mehrere Vorschläge, einen Teil des elektrisch nicht geladenen Dampfes in einer separaten Ionisierungskammer nach dem Prinzip der Massenspektroskopie zu ionisieren und für die Prozeßregelung zu nutzen. Für die Steuerung mehrerer Verdampfer zur Herstellung von Legierungsschichten haben solche massenspektrometrischen Methoden eine beschränkte Anwendung gefunden. Neben dem relativ hohen Aufwand dieser Methoden besteht jedoch der entscheidende Nachteil, daß das Meßsignal in einer separaten Ionisierungskammer gewonnen wird und nur sehr gering mit den Prozeßbedingungen in der Bedampfungskammer korreliert. Auch Überlegungen, die Prozeßkontrolle mittels der Laserabsorptionsspektroskopie zu erreichen, haben bisher noch nicht zum Erfolg geführt. Gründe dafür sind neben verfahrenstechnischen Problemen vor allem die hohen Kosten für solche Systeme.

Der Erfindung liegt die Aufgabe zugrunde, ein Verfahren und die zugehörige Einrichtung zu schaffen, um den Prozeß des Elektronenstrahlverdampfens zu stabilisieren. Es sollen örtlich homogene Schichten konstanter Eigenschaften, besonders im Langzeitbetrieb, bei Verwendung von axialen Elektronenkanonen aufgebracht werden. Der apparative Aufwand soll relativ gering sein und die Einrichtung soll mit hoher Zuverlässigkeit arbeiten.

Erfindungsgemäß wird die Aufgabe nach den Merkmalen des Anspruches 1 gelöst. Die zugehörige Einrichtung ist nach den Merkmalen der weiteren Ansprüche aufgebaut.

Ein besonderer Vorteil des erfindungsgemaßen Verfahrens liegt darin begründet, daß der physikalische Grundprozeß, der für die Dampferzeugung beim Elektronenstrahlverdampfen genutzt wird, und die Intensität der emittierten Strahlung zur Gewinnung des verknüpften Signals in sehr enger Beziehung stehen, und in Bezug auf die örtlichen und zeitlichen Schwankungen dieser Prozesse damit eine sehr enge Korrelation existiert. Die Entstehungsorte der Dampfverteilung und der Emissionsstrahlung stimmen weitgehend überein. Beide Quellverteilungen werden durch die nahe Umgebung des auf das Verdampfungsgut auftreffenden Elektronenstrahls bestimmt. Die Wechselwirkungen des Elektronenstrahles mit der dichten Dampfwolke im Dampfausbreitungsraum sind sowohl für den Elektronenstrahlbedampfungsprozeß als auch für die emittierte Strahlung entscheidend.

Der Charakter der emittierten Strahlung wird darüber hinaus auch durch die Wechselwirkung des Dampfes mit dem gegebenenfalls eingelassenen reaktiven Gas bestimmt. Es hat sich gezeigt, daß das erfindungsgemäß gebildete Gesamtsignal als Führungsgröße einer Regelstrecke, die vorzugsweise die Fokussierung des Elektronenstrahles als Regler eines Regelkreises enthält und gegebenenfalls die Leistung der Elektronenkanone einschließt, besser als die bekannten Signale für die Prozeßstabilisierung geeignet ist.

Die nach dem erfindungsgemäßen Verfahren mögliche Prozeßstabilisierung wirkt in unmittelbarer Weise und mit extrem kurzer Zeitkonstante auf die physikalische Ursache von Stabilitätsschwankungen, d. h. der Störgrößen des Regelkreises, ein, woraus sich die Wirksamkeit des Verfahrens erklärt.

Das Verfahren nutzt die Emissionsstrahlung, die von der Zone intensiver Wechselwirkung des Elektronenstrahles mit dem Dampf ausgeht, und benötigt damit keine materiellen Einrichtungen im Bereich höchster Dampfdichte. Die erforderlichen Sensoren sind außerhalb der Region höchster Dampfdichte angeordnet, wodurch ihre Beschichtung auf ein tolerierbares Maß reduziert wird. Darin liegt die Anwendbarkeit des Verfahrens für die Prozeßstabilisierung bei hoher Verdampfungsrate begründet.

Die Erfassung der Intensität der Strahlung an mehreren Orten im Dampfausbreitungsraum und deren Verknüpfung zu einem Signal erlaubt es, die Prozeßstabilisierung auch und besonders erfolgreich dann durchzuführen, wenn örtliche und zeitliche Instabilitäten des Verdampfungsprozesses zu unsystematischen Schwankungen der Dampfdichteverteilung führen. Ursachen solcher Schwankungen sind z. B. Kraterbildung im Verdampfungsgut bei sublimierenden Materialien, Gasausbrüche bei unvollständig entgastem oder dissoziierendem Verdampfungsgut, Schlackebildung auf der Schmelzbadoberfläche, die das Verdampfungsgut prozeßbedingt bildet, oder Reaktionsprodukte mit dem eingelassenen reaktiven Gas, die das Verdampfungsgut teilweise oder ganz bedecken.

Die Auswahl der für die Intensitätserfassung genutzten Spektrallinie bzw. des spektralen Wellenlängenbereiches ist durch die physikalisch-chemische Natur des Verdampfungsgutes und ggf. des reaktiven Gases bestimmt. Entsprechend dem Charakter des Emissionsspektrums kann die Auswahl und Festlegung der spektralen Grenzen z. B. durch Filter oder selektive faseroptische Elemente zur Übertragung der Sensordaten in an sich bekannter Weise erfolgen. Besonders zweckmäßig und adaptierbar für eine Anzahl unterschiedlicher Verdampfungsgüter ist die Verwendung schmalbandiger selektiver Filter und breitbandiger Übertragungs- und Vervielfacher-Elemente.

Es kann auch zweckmäßig sein, das erfindungsgemaße Signal zur Prozeßstabilisierung nicht als Absolutwert, sondern in Relation zur Temperatur des Verdampfungsgutes zu bilden und zu nutzen. In diesem Fall wird zusätzlich die Temperaturstrahlung des Verdampfungsgutes über einen breiten Spektralbereich, vorzugsweise über den Gesamtbereich von 0,1 µm bis 1 µm, erfaßt und zur Normierung des erfindungsgemäß gebildeten Signales benutzt.

Es kann auch vorteilhaft sein, das Verfahren zur Stabilisierung des Verdampfungsprozesses für großflächige Verdampfungsanordnungen derart durchzuführen, daß die Oberfläche des Verdampfungsgutes in einzelne Bereiche unterteilt wird. Jedem Bereich werden mindestens zwei Orte zugeordnet, an denen die Intensität der Strahlung erfaßt wird. Besagtes Signal wird für jeden Bereich getrennt gebildet. Damit werden z. B. die Fokussierung des Elektronenstrahles und die Leistung der Elektronenkanone derart geregelt, daß das Signal für jeden Abschnitt konstant ist.

Es ist möglich, an mehreren Orten mit Sensoren, getrennten optischen Übertragungselementen und Verstärkern die Intensität der Strahlung zu erfassen, zu wandeln und einer Auswerteelektronik zum Zweck der Verknüpfung zu einem Gesamtsignal zuzuführen. Diese Verfahrensweise ist bei sehr hoher Rate und bei hohen Flexibilitätsforderungen zweckmäßig. Weiterhin kann es zweckmäßig sein, die erfaßten und übertragenen Meßwerte der Intensität jedoch vor deren Verstärkung zu verknüpfen, um die zugehörigen Einrichtungen weniger aufwendig zu gestalten.

Eine weitere vorteilhafte Ausgestaltung des Verfahrens besteht darin, daß die Intensität der Strahlung an mehreren Orten des Dampfausbreitungsraumes erfaßt wird und deren Verknüpfung mit optischen Mitteln bereits innerhalb der Bedampfungsanlage erfolgte, ehe der verknüpfte Meßwert mittels Übertragungs- und Verstärkungselementen zu einem Gesamtsignal gewandelt wird. Diese Verfahrensweise setzt voraus, daß wirksame Mittel zum Bedampfungsschutz der Sensoren und der optischen Mittel zur Verknüpfung vorhanden sind und die angewandte Verdampfungsrate nicht extrem hoch ist.

Die Einrichtung zur Durchführung des Verfahrens umfaßt neben bekannten Komponenten - wie Sensoren für die Strahlung, optische Elemente zur Meßwertübertragung, vornehmlich Faseroptiken, Verstärkerelemente und Regelkreise - erfindungsgemäß Mittel zur Unterdrückung der Temperaturstrahlung an den Sensoren und Mittel zum Bedampfungsschutz der Sensoren.

An einem Ausführungsbeispiel wird die Erfindung näher erläutert. In der zugehörigen Zeichnung ist eine Einrichtung zum Elektronenstrahlverdampfen mit Prozeßstabilisierung schematisch dargestellt.

An einer Bedampfungskammer 1 ist eine Elektronenkanone 2 vom Axialtyp mit zugehörigem Strahlführungs- und Fokussierungssystem sowie getrennter Vakuumerzeugung mit Druckstufen (Baugruppen nicht gezeichnet) angeflanscht. Der mit der Elektronenkanone 2 erzeugte Elektronenstrahl 3 trifft geeignet programmiert auf die Oberfläche des Verdampfungsgutes 4 und erzeugt dabei einen hohen Dampfdruck in dem Dampfausbreitungsraum 5 zwischen dieser Oberfläche und einem darüber angeordneten zu bedampfenden Substrat 6. Die Region 7 höchster Dampfdichte befindet sich in der Umgebung des Auftreffortes des Elektronenstrahls 3 auf das Verdampfungsgut 4. Als Verdampfungsgut 4 dient ein Block aus Siliziumdioxid (SiO₂). Dieses Material dissoziiert unter intensiver und unregelmäßiger Gasabgabe. Um stöchiometrische SiO₂-Schichten aufzudampfen, wird mit einer Gaseinlaß-Einrichtung 8 ein bestimmter Strom des reaktiven Gases Sauerstoff eingelassen. Die Leistung der Elektronenkanone 2 beträgt 40...50 kW. Durch eine hohe Temperatur an der Oberfläche des Verdampfungsgutes 4 wird eine intensive Temperaturstrahlung emittiert (schematisch durch die Strahlen 9 dargestellt). Ziel des Elektronenstrahlverdampfens ist die Abscheidung einer Schicht 10 auf dem Substrat 6 mit einer Abscheidegeschwindigkeit von 0,3 µm s⁻¹. Es ist unvermeidbar, daß auch die Innenflächen der Bedampfungskammer 1 und alle Bauteile im Inneren derselben beschichtet werden.

Im technischen Bereich ist es ohne Prozeßstabilisierung unvermeidbar, daß eine Reihe von Störgrößen zu Instabilitäten des Prozesses und damit zu Abweichungen der Schichteigenschaften von den angestrebten Parametern der Schicht 10 führen. Solche Störgrößen liegen im Verdampfungsprozeß selbst wie auch in einer Beeinflussung des Dampfes bei der Ausbreitung im Dampfausbreitungsraum 5 begründet. Sie sind nicht vollständig aufgeklärt und lassen sich mehrheitlich nicht beeinflussen. Beim vorliegenden Prozeß der SiO₂-verdampfung entstehen z. B. lokale Krater in der Oberfläche des Verdampfungsgutes 4. Reaktionen des hoch erhitzten Verdampfungsgutes 4 mit dem reaktiven Gas und dem Restgas in der Bedampfungskammer 1 sind weitere Störgrößen. Beobachtet werden auch Gasausbrüche bei der Dissoziation des Verdampfungsgutes 4 SiO₂, die zu Störungen bei der Dampfausbreitung führen. Insgesamt ist dadurch die Dampfdichte örtlichen und zeitlichen Schwankungen unterworfen.

Das erfindungsgemaße Verfahren zur Prozeßstabilisierung wird wie folgt durchgeführt:

Unter der direkten Wechselwirkung des Elektronenstrahls 3 mit dem Dampf, dem Restgas und dem reaktiven Gas Sauerstoff entsteht im gesamten Dampfausbreitungsraum 5 eine elektromagnetische Strahlung. Die Untersuchung dieser Strahlung ergibt, daß ihre spektrale Energieverteilung, d. h. die wellenlängenabhängige Intensität, nicht vollständig mit der Temperaturstrahlung des heißen Verdampfungsgutes 4 übereinstimmt. Es wird die durch direkte Wechselwirkung des Elektronenstrahles 3 im Dampfausbreitungsraum 5 entstehende Strahlung in einem Wellenlängenbereich zwischen 249 nm und 251 nm gemessen. Dieser Wellenlängenbereich im Ultraviolettgebiet nahe dem sichtbaren Wellenlängenbereich wird durch ein Interferenzfilter selektiert. Dazu dienen Sensorensysteme, die im folgenden näher beschrieben werden. Die zugehörigen drei Sensoren 11.1; 11.2; 11.3 sind im Dampfausbreitungsraum 5 im Abstand von 20 mm, 50 mm und 100 mm vom Verdampfungsgut 4 angeordnet, jedoch 400 mm seitlich von der Verbindungslinie zwischen den Zentren des Verdampfungsgutes 4 und des Substrates 6. Sie befinden sich damit außerhalb der Region 7 höchster Dampfdichte. Als Mittel zur Unterdrückung der Temperaturstrahlung des Verdampfungsgutes 4 an den Sensoren 11 befinden sich Blenden 12 mit Durchbrüchen zwischen den Sensoren 11 und dem Verdampfungsgut 4. Die Sensoren 11 haben eine geringe Empfängerfläche von 2 mm und tragen als Mittel zum Bedampfungsschutz Aperturblenden 13 in Form dünnwandiger Kapillarrohre mit einer Länge von 40 mm. Um die Temperaturstrahlung des Verdampfungsgutes 4 an den Sensoren 11 weiter zu unterdrücken, ist jeder dieser Sensoren 11 auf die Öffnung 14 eines zugeordneten Strahlungsabsorbers 15 gerichtet. Die Strahlungsabsorber 15 sind ebenfalls außerhalb der Region 7 höchster Dampfdichte angeordnet und mit Aperturblenden 16 für die Unterdrückung der Temperaturstrahlung und zum Schutz gegen Bedampfung versehen. Die Strahlungsabsorber 15 sind als Hohlkörper ausgebildet. Ihre Innenfläche ist aufgerauht, geschwärzt und mit Zwischenwänden 17 ausgestattet. Der Bereich 18 der Innenwand des Strahlungsabsorbers 15, der sich gegenüber seiner Öffnung 14 befindet, hat dagegen eine glatte hochreflektierende Oberfläche. Insgesamt sichert diese Ausgestaltung des Strahlungsabsorbers 15 die hochgradige Strahlungsabsorption für die Temperaturstrahlung, die vom Verdampfungsgut 4 emittiert wird, vor allem bei einem langen Betrieb des Verdampfungsprozesses mit hoher Verdampfungsrate.

Mit Hilfe von Lichtleitfasern 19 und Sekundärelektronenvervielfachern 20 werden die Meßwerte der Intensität der Strahlung aus der Bedampfungskammer 1 geführt, verstärkt und gewandelt und danach als Einzel-Meßwerte einer üblichen Verknüpfungseinheit 21 zugeführt. Durch Verknüpfung, gewichtete Addition mit den Proportionalitätsfaktoren 1 für Sensor 11.1 (40 mm), 6 für Sensor 11.2 (50 mm) und 20 für Sensor 11.3 (100 mm), wird in einer Signalverarbeitungseinheit 22 ein Gesamtsignal gebildet. Der Verknüpfungsalgorithmus hängt von der geometrischen Anordnung ab und bestimmt die Größe der Regelabweichungen, jedoch nicht die prinzipielle Anwendbarkeit des Verfahrens. Das so gewonnene Gesamtsignal dient als Führungsgröße für einen Regler 23. Der zugehörige Regelkreis regelt mit einer Zeitkonstante von 100 ms die Fokussierung der Elektronenkanone 2 derart, daß einer Signaländerung von -10 % eine Erhöhung der mittleren Leistungsdichte am Auftreffort des Elektronenstrahls 3 auf das Verdampfungsgut 4 von +3 % entspricht. Überschreitet die Abweichung der Regelgröße einen Wert von 30 %, so bewirkt die zweite Regelstufe mit einer Zeitkonstante von 3 s, daß die Leistung der Elektronenkanone 2 um 5 % verändert wird.

Es besteht auch mit Hilfe des erfindungsgemäßen Verfahrens die Möglichkeit, das besagte Gesamtsignal mittels anderer bekannter Regelkreise konstant zu halten. So kann dieses Gesamtsignal auch verwendet werden, um das Verdampfungsgut 4 relativ zum Auftreffort des Elektronenstrahls 3 zu bewegen. Damit kann eine Stabilisierung des Verdampfungsprozesses bei gleichmäßigem Abtrag des Verdampfungsgutes 4 und Vermeidung von starker Kraterbildung erreicht werden. Für die Mehrzahl der untersuchten Verdanpfungsgüter hat sich jedoch die Regelung durch Veränderung der Fokussierung und ggf. der Leistung des Elektronenstrahls 3 als zweckmäßigste Ausgestaltung des Verfahrens zur Prozeßstabilisierung erwiesen.

Das beschriebene Verfahren, welches mit der in der Fig. dargestellten Einrichtung ausgeübt wird, kann auch im Prinzip bei einem großflächigen Verdampfer Anwendung finden; so z. B. bei der Verdampfung von SiO₂. Das Verdampfungsgut SiO₂ liegt zweckmäßig als ein um seine Längsachse rotierendes Quarzrohr vor. Der Elektronenstrahl 3 wird periodisch mittels eines elektromagnetischen Ablenksystems, welches Bestandteil der Elektronenkanone ist, nacheinander zu drei Auftreffstellen (Bereichen) auf dem Verdampfungsgut 4 geführt, die im Abstand von jeweils 150 mm liegen. Damit wird ein Substrat 6 mit einer Breite von 400 mm, welches sich relativ zum Verdampfungsgut 4 gleichförmig bewegt, gleichmäßig beschichtet. Zur Prozeßstabilisierung werden drei gleichartige Sensorsysteme (9 Sensoren) der oben beschriebenen Art verwendet. Diese Sensorsysteme sind auf einer Linie parallel zur Achse des Quarzrohres und mit einem Abstand von ebenfalls jeweils 150 mm angeordnet. Erfindungsgemäß wird in jedem der Bereiche, denen ein Auftreffpunkt des Elektronenstrahls 3 und ein Sensorsystem zugeordnet ist, ein separates Gesamtsignal gebildet. Der Regelkreis ist dann dahingehend ausgestaltet, daß alle Gesamtsignale konstant gehalten werden.

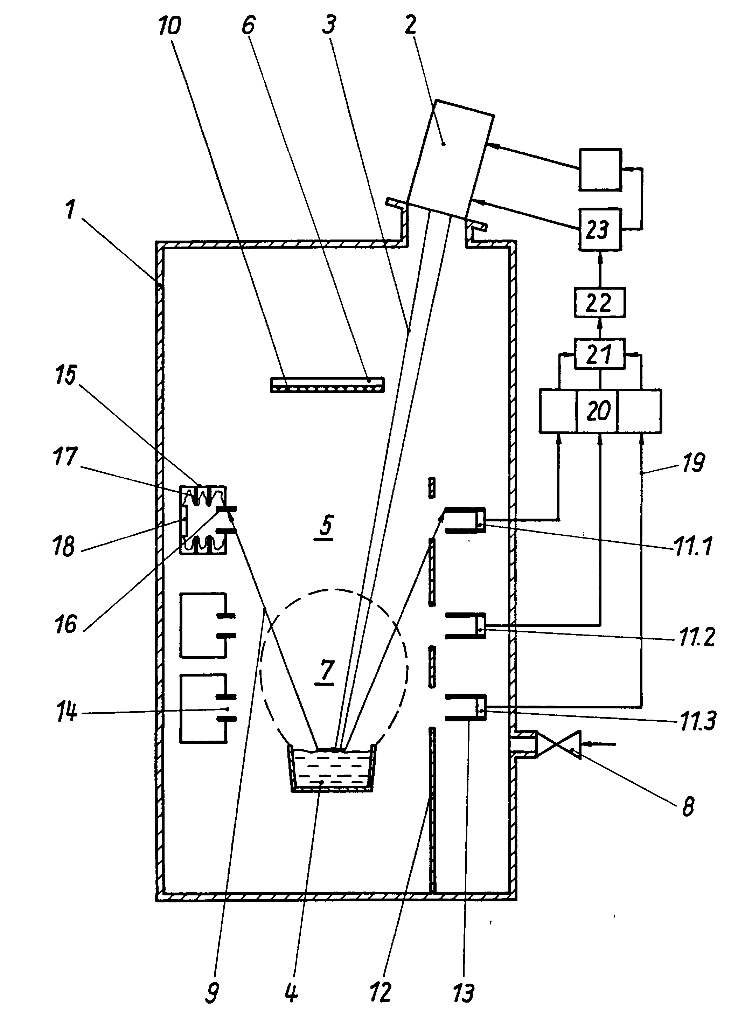

## Patentansprüche

1. Verfahren zur Prozeßstabilisierung beim Elektronenstrahlverdampfen, insbesondere von Metallen und Verbindungen mit hoher Verdampfungsrate, gegebenenfalls bei Einlaß eines reaktiven Gases, unter Verwendung einer Elektronenkanone vom Axialtyp, **gekennzeichnet dadurch**, daß an mindestens zwei Orten in dem zwischen dem Verdampfungsgut und dem zu beschichtenden Substrat liegenden Dampfausbreitungsraum und in mindestens einem Bereich der Oberfläche des Verdampfungsgutes die Intensität mindestens einer Spektrallinie oder mindestens eines begrenzten Spektralbereiches aus dem Wellenlängenbereich zwischen 0,1 µm und 1 µm der durch direkte Wechselwirkung des von der Elektronenkanone erzeugten Elektronenstrahles mit dem Dampf und gegebenenfalls dem reaktiven Gas emittierten Strahlung erfaßt und zu einem Gesamtsignal verknüpft wird, daß mit diesem Gesamtsignal, vorzugsweise in einem zweistufigen Regelkreis, in dessen erster Regelstufe mit einer kleinen Zeitkonstante von τ₁ < 1s die Fokussierung des Elektronenstrahls und in dessen zweiter Regelstufe mit einer Zeitkonstante von τ₂ > τ₁ die elektrische Leistung der Elektronenkanone geregelt wird, dieses Gesamtsignal konstant gehalten wird.

2. Einrichtung zur Durchführung des Verfahrens nach Anspruch 1, bestehend aus in einer Bedampfungskammer angeordneten Sensoren, optischen Übertragungs- und Verstärkungselementen und einer Auswerteelektronik, **gekennzeichnet durch** folgende Merkmale:
- im Dampfausbreitungsraum (5), außerhalb der Region (7) der höchsten Dampfdichte, sind an mindestens zwei Orten zwischen dem zu beschichtenden Substrat (6) und dem Verdampfungsgut (4) und in mindestens einem Bereich der Oberfläche des Verdampfungsgutes (4) Sensoren (11) angeordnet,
- zur Unterbrechung des direkten Strahlenganges der von der heißen Oberfläche des Verdampfungsgutes (4) an der Auftreffstelle des Elektronenstrahles (3) emittierten Temperaturstrahlung zum Sensor (11) sind in dem Strahlengang Blenden (12) angeordnet,
- die Empfängerfläche der Sensoren (11) ist auf die Öffnung eines Strahlenabsorbers (15) gerichtet,
- an den Sensoren (11) sind Aperturblenden (13) mit derartigen geometrischen Abmessungen angeordnet, daß die Beschichtungsrate der Empfängerfläche gering ist,
- der Strahlenabsorber (15) ist als Hohlkörper ausgebildet, der mit Ausnahme besagter Öffnung allseitig geschlossen ist und in seinem Inneren sind an sich bekannte Gestaltungselemente zur Erzeugung von Mehrfachreflexion eingebracht,
- zur Unterbrechung der direkten Verbindung zwischen der Auftreffstelle des Elektronenstrahles (3) auf das Verdampfungsgut (4) und der Öffnung (14) des Strahlenabsorbers (15) sind Blenden (16) angeordnet.

3. Einrichtung nach Anspruch 2, **dadurch gekennzeichnet**, daß jedem Sensor (11) für jeden Ort und Bereich getrennte optische Übertragungs- und Verstärkungselemente zur Bildung des Gesamtsignals angeordnet sind.

4. Einrichtung nach Anspruch 2 und 3, **dadurch gekennzeichnet**, daß die optischen Übertragungselemente in der Bedampfungskammer (1) angeordnet sind und daß die Verstärkungselemente außerhalb der Bedamfpungskammer (1) angeordnet sind.

5. Einrichtung nach Anspruch 2 und 3, **dadurch gekennzeichnet**, daß die optischen Übertragungs- und Verstärkungselemente in der Bedampfungskammer (1) angeordnet sind.

6. Einrichtung nach Anspruch 2 und 3, **dadurch gekennzeichnet**, daß zur Erfassung der Intensität der Strahlung, die an mindestens zwei Orten im Dampfausbreitungsraum (5) entsteht, in der Bedampfungskammer (1) optische Mittel zur Verknüpfung der gewonnenen Signale angeordnet sind, und daß die Verstärkungselemente außerhalb der Bedampfungskammer (1) angeordnet sind.

7. Einrichtung nach Anspruch 2 bis 6, **dadurch gekennzeichnet**, daß die Verstärkungselemente Sekundärelektronenvervielfacher sind.

## Claims

1. Method for process stabilization in electron beam vaporization, particularly of metals and compounds at a high vaporization rate and optionally accompanied by the introduction of a reactive gas, using an axial electron gun, characterized in that at at least two points in the vapor propagation area located between the vaporization material and the substrate to be coated and in at least one area of the surface of the vaporization material the intensity of at least one spectral line or at least one limited spectral area from the wavelength range between 0.1 µm and 1 µm of the radiation emitted by direct interaction of the electron beam produced by the electron gun with the vapor and optionally the reactive gas is determined and linked with a total signal, that with said total signal, preferably in a two-stage control loop, in whose first control stage with a small time constant of τ₁ < 1s the focusing of the electron beam is controlled and in its second control stage with a time constant of τ₂ > τ₁ the electric power of the electron gun is controlled, said total signal is kept constant.

2. Apparatus for performing the method according to claim 1, comprising sensors, optical transmission and amplification elements and evaluation electronics located in a vaporizing chamber, characterized by the following features:
- in the vapor propagation area (5), outside the maximum vapor density region (7), at at least two points between the substrate (6) to be coated and the vaporization material (4) and in at least one area of the surface of the vaporization material (4) sensors (11) are provided,
- for interrupting the direct optical path of the thermal radiation to the sensor (11) emitted by the hot surface of the vaporization material (4) at the impact point of the electron beam (3) diaphragms (12) are located in the optical path,
- the receiver surface of the sensors (11) is directed at the opening of a beam absorber (15),
- at the sensors (11) are provided aperture diaphragms (13) with geometrical dimensions such that the coating rate of the receiver surface is low,
- the beam absorber (15) is constructed as a hollow body, which with the exception of said opening is closed on all sides and in its interior are introduced per se known design elements for producing multiple reflections,
- for interrupting the direct connection between the impact point of the electron beam (3) on the vaporization material (4) and the opening (14) of the beam absorber (15) diaphragms (16) are provided.

3. Apparatus according to claim 2, characterized in that with each sensor (11) for each location and area are associated separate optical transmission and amplification elements for forming the total signal.

4. Apparatus according to claim 2 and 3, characterized in that the optical transmission elements are located in the vaporizing chamber (1) and that the amplification elements are located outside the vaporizing chamber (1).

5. Apparatus according to claim 2 and 3, characterized in that the optical transmission and amplification elements are located in the vaporizing chamber (1).

6. Apparatus according to claim 2 and 3, characterized in that for determining the intensity of the radiation occurring at at least two points in the vapor propagation area (5), in the vaporizing chamber (1) are provided optical means for linking the signals obtained and that the amplification elements are located outside the vaporizing chamber (1).

7. Apparatus according to claims 2 to 6, characterized in that the amplification elements are secondary electron multipliers.

## Revendications

1. Procédé de stabilisation du processus en émission thermoélectronique, en particulier pour la vaporisation de métaux et composés, à haut taux de vaporisation, éventuellement à admission d'un gaz réactif, à emploi d'un canon électronique du type axial,
**caractérisé en ce** que l'intensité d'au moins une raie spectrale ou d'au moins une gamme spectrale limitée de la gamme de longueurs d'onde entre 0,1 µm et 1 µm du rayonnement émis par l'interaction directe entre le faisceau électronique engendré par ledit canon électronique, d'une part, et la vapeur et éventuellement ledit gaz réactif, d'autre part, est détectée à au moins deux lieux dans l'espace de propagation de la vapeur, formé entre le matériel à vaporiser et le substrat à métalliser, et dans au moins une zone de la surface dudit matériel à vaporiser, et que l'intensité détectée est lié à former un signal combiné; et en ce que ce signal combiné est tenu à un niveau constant, de préférence dans une boucle d'asservissement à deux étage, dont le premier étage de réglage, à une petite constante de temps de τ₁ < 1s, réalise la focalisation du faisceau électronique et dont le deuxième étage de réglage, à une constante de temps de τ₂ > τ₁, asservit la puissance électrique du canon électronique.

2. Dispositif à réaliser le procédé selon la revendication 1, comprenant des détecteurs, des éléments optiques de transmission et amplification, qui sont disposés dans une chambre de métallisation, ainsi qu'une logique d'évaluation,
**caractérisé par** les caractéristiques suivantes:
- des détecteurs (11) sont disposés dans l'espace de propagation de vapeur (5), hors de la région (7) à densité maximale de la vapeur, à au moins deux lieux entre le substrat (6) à métalliser et le matériel (4) à vaporiser et dans au moins une zone de la surface dudit matériel (4) à vaporiser,
- des diaphragmes (12) sont disposés dans la marche de rayons afin d'interrompre la marche de rayon direct du rayonnement thermique émis de la surface chaude dudit matériel (4) à vaporiser au point d'incidence dudit faisceau électronique (3),
- la surface réceptrice desdits détecteurs (11) est orientée sur l'ouverture d'un élément d'absorption de rayonnement (15),
- des diaphragmes d'ouverture (13) sont disposés auxdits détecteurs (11) à dimensions géométriques telles que le taux de métallisation de ladite surface réceptrice soit bas,
- ledit élément d'absorption de rayonnement (15) est prévu sous forme d'un corps creux qui est fermé de tout côté, à l'exception de ladite ouverture, et des éléments de formation connus en soi sont introduits dans son intérieur afin d'engendrer des réflexions multiples,
- des diaphragmes (16) sont disposés afin d'interrompre la jonction directe entre le point d'incidence dudit faisceau électronique (3) sur ledit matériel (4) à vaporiser et ladite ouverture (14) dudit élément d'absorption de rayonnement (15).

3. Dispositif selon la revendication 2, **caractérisé en ce** que des éléments optiques de transmission et amplification, séparément pour chaque lieu et chaque zone et affectés à chacun desdits détecteurs, sont disposés afin de former le signal combiné.

4. Dispositif selon les revendications 2 et 3, **caractérisé en ce** que lesdits éléments optiques de transmission sont disposés à l'intérieur de ladite chambre de métallisation (1), et en ce que lesdits éléments d'amplification sont disposés en dehors de ladite chambre de métallisation (1).

5. Dispositif selon les revendications 2 et 3, **caractérisé en ce** que lesdits éléments optiques de transmission et amplification sont disposés dans ladite chambre de métallisation (1).

6. Dispositif selon les revendications 2 et 3, **caractérisé en ce** que des moyens optiques, prévus à lier les signaux obtenus, sont disposés dans ladite chambre de métallisation (1) afin de détecter l'intensité du rayonnement provoqué à au moins deux lieux dans ledit espace de propagation de vapeur (5), et en ce que lesdits éléments d'amplification sont disposés en dehors de ladite chambre de métallisation (1).

7. Dispositif selon les revendications 2 à 6, **caractérisé en ce** que lesdits éléments d'amplification sont des multiplicateurs des électrons secondaires.
